# EUROPEAN PATENT SPECIFICATION

(11) **EP 3 385 050 B1**
(45) Date of publication and mention of the grant of the patent: **21.08.2019**
(21) Application number: 18156243.0
(22) Date of filing: 12.02.2018
(51) Int. Cl.: B29C 39/42, B29C 41/50, B22D 19/00, B29L 31/18

(54) **METHOD OF MANUFACTURING HEAT SINK**
VERFAHREN ZUR HERSTELLUNG EINES WÄRMETAUSCHERS
PROCÉDÉ DE FABRICATION DE DISSIPATEUR THERMIQUE

(30) Priority: 03.04.2017 JP 2017073806
(43) Date of publication of application: 10.10.2018
(73) Proprietor: TOYOTA JIDOSHA KABUSHIKI KAISHA, Toyota-shi, Aichi, 471-8571 (JP)
(72) Inventor: MIURA, Mitsuhiro, Aichi 471-8571 (JP); EGAWA, Yuta, Aichi 471-8571 (JP)
(74) Representative: TBK

(56) References cited:
- EP-A2- 2 656 991
- JP-A- S57 202 683

## Description

### BACKGROUND

The present disclosure relates to a method of manufacturing a heat sink.

Japanese Unexamined Patent Application Publication No. 57-202683 discloses a method of manufacturing a heat sink including a base material having a surface on which a heat-radiation resin-coated film is formed. Specifically, a base material which has just been die-cast and hence has a high temperature is introduced into a mold for injection molding and heat-radiation resin is injection molded, whereby the heat-radiation resin-coated film is formed on the surface of the base material. Since the base material which has just been die-cast and hence has a high temperature is introduced into the mold for injection molding, there is no need to separately heat the base material and thus productivity is high.

EP 2 656 991 A2 discloses a method and device for casting resin or resin components.

### SUMMARY

The present inventors have found the following problems in the method of manufacturing the heat sink including the base material having the surface on which the heat-radiation resin-coated film is formed.

In the method disclosed in Japanese Unexamined Patent Application Publication No. 57-202683, as described above, the base material is introduced into the mold for injection molding and the heat-radiation resin is injection molded. Therefore, since the thickness of the heat-radiation resin-coated film formed on the surface of the base material tends to vary depending on the place on this film, it is quite difficult to make the thickness of the heat-radiation resin-coated film uniform.

On the other hand, it may be possible to apply the heat-radiation resin onto the surface of the base material as a method of forming the heat-radiation resin-coated film on the surface of the base material without using a mold. Specifically, the heat-radiation resin is applied to the base material having a high temperature since it has just been die-cast by spraying the heat-radiation resin onto the base material or dropping the heat-radiation resin onto the base material. However, even in the method of applying the heat-radiation resin to the surface of the base material without using a mold, since the thickness of the heat-radiation resin-coated film tends to vary depending on the place on this film, it is difficult to make the thickness of the heat-radiation resin-coated film uniform.

The present disclosure has been made in view of the aforementioned circumstances and provides a method of manufacturing a heat sink in which there is no need to separately heat the base material in order to form the heat-radiation resin-coated film and thus productivity can be made high, and the thickness of the heat-radiation resin-coated film formed on the surface of the base material can be made uniform.

The object of the present invention is achieved with a method of manufacturing a heat sink according to claim 1. Further advantageous developments are subject-matter of the dependent claims.

A method of manufacturing a heat sink according to the present invention is a method of manufacturing a heat sink including a base material having a surface on which a heat-radiation resin-coated film is formed, the method including: taking the base material out of a die-casting mold after the base material is die-cast; and forming the heat-radiation resin-coated film on the surface of the base material using residual heat of the base material taken out of the die-casting mold, wherein in forming the heat-radiation resin-coated film, the heat-radiation resin-coated film is formed on the surface of the base material by bonding a heat-radiation resin film to the surface of the base material.

In the method of manufacturing the heat sink according to the present invention, in forming the heat-radiation resin-coated film on the surface of the base material using residual heat of the base material taken out of the die-casting mold, the heat-radiation resin film is bonded to the surface of the base material, to thereby form the heat-radiation resin-coated film on the surface of the base material. Accordingly, it is possible to eliminate the need for separately heating the base material in order to form the heat-radiation resin-coated film, thereby making productivity high, and make the thickness of the heat-radiation resin-coated film formed on the surface of the base material uniform.

By interposing the heat-radiation resin film between a die for bonding having a surface shape that corresponds to the surface shape of the base material and the base material, the heat-radiation resin film is bonded to the surface of the base material. According to this structure, the heat-radiation resin film can be efficiently bonded to the surface of the base material.

A vacuum hole for vacuum adsorption is provided in the die for bonding, and the heat-radiation resin film is interposed between the die for bonding and the base material in a state in which the heat-radiation resin film is vacuum adsorbed to the die for bonding. According to this structure, it is possible to suppress wrinkles of the resin film F that may occur at the bonding process.

Adhesive may be applied to a surface of the heat-radiation resin film, and the heat-radiation resin film may be bonded to the surface of the base material using the adhesive. According to this structure, it is possible to improve the bonding force between the heat-radiation resin film and the base material.

The adhesive may be made of heat-radiation resin.

According to the present disclosure, it is possible to provide a method of manufacturing a heat sink in which there is no need to separately heat the base material in order to form the heat-radiation resin-coated film and thus productivity can be made high, and the thickness of the heat-radiation resin-coated film formed on the surface of the base material can be made uniform.

The above and other objects, features and advantages of the present invention will become more fully understood from the detailed description given hereinbelow and the accompanying drawings which are given by way of illustration only, and thus are not to be considered as limiting the present invention.

### BRIEF DESCRIPTION OF DRAWINGS

Fig. 1 is a cross-sectional view of one example of a heat sink manufactured by a method of manufacturing a heat sink according to a first embodiment;
Fig. 2 is a flowchart showing the method of manufacturing the heat sink according to the first embodiment;
Fig. 3 is a flowchart showing details of the method of manufacturing the heat sink according to the first embodiment;
Fig. 4 is a schematic cross-sectional view showing a state in which molten metal M is supplied to a plunger sleeve 13 in a die-casting process;
Fig. 5 is a schematic cross-sectional view showing a state in which injection of the molten metal M into a cavity C is completed in the die-casting process;
Fig. 6 is a schematic cross-sectional view showing a state in which a base material B is taken out of a mold (a movable mold 11 and a fixed mold 12) in the die-casting process;
Fig. 7 is a schematic side view showing a state in which a resin film F is placed on a lower mold 22 in a bonding process;
Fig. 8 is a schematic plane view of the lower mold 22;
Fig. 9 is a schematic side view showing a state in which the resin film F is vacuum adsorbed to the lower mold 22 in the bonding process;
Fig. 10 is a schematic side view showing a state in which the base material B is placed on the lower mold 22 and the base material B is pressed by an upper mold 21 in the bonding process;
Fig. 11 is a schematic side view showing a state in which the base material B to which the resin film F has been bonded is taken out of the lower mold 22 in the bonding process;
Fig. 12 is a flowchart showing details of a method of manufacturing a heat sink according to a second embodiment; and
Fig. 13 is a schematic side view showing a state in which adhesive is sprayed onto the resin film F in the bonding process.

### DESCRIPTION OF EMBODIMENTS

Hereinafter, specific embodiments to which the present disclosure has been applied will be explained in detail with reference to the drawings. However, the present disclosure is not limited to the following embodiments. Further, in order to clarify the explanation, the following descriptions and the drawings are simplified as appropriate.

### (First Embodiment)

### <Structure of Heat Sink>

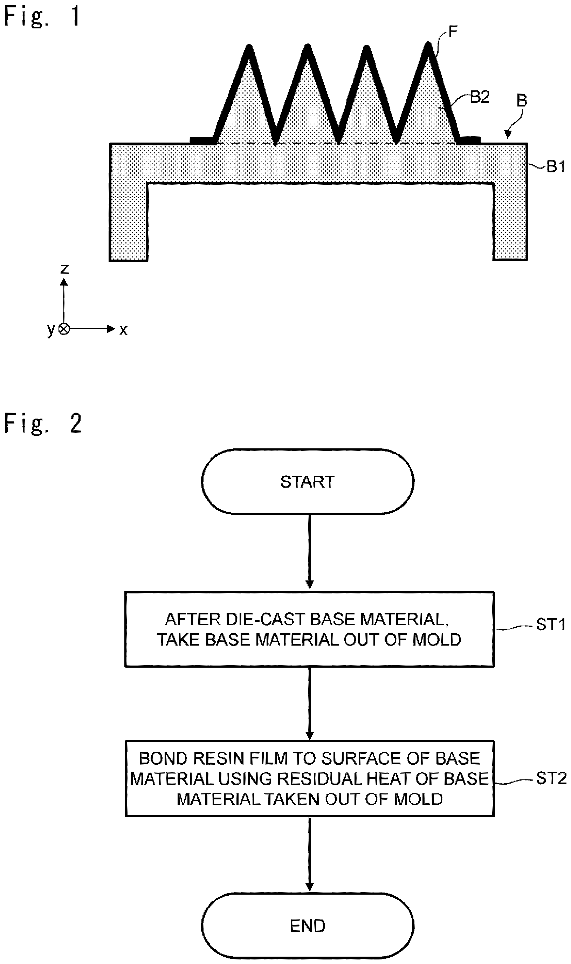

With reference first to Fig. 1, a heat sink manufactured by a method of manufacturing a heat sink according to a first embodiment will be explained. Fig. 1 is a cross-sectional view of one example of the heat sink manufactured by the method of manufacturing the heat sink according to the first embodiment. As shown in Fig. 1, the heat sink manufactured by the method of manufacturing the heat sink according to this embodiment includes a base material B and a resin film F, and is suitably used, for example, as a heat-radiation member used for a semiconductor device etc.

As a matter of course, the right-handed xyz rectangular coordinates shown in Fig. 1 and the other drawings are merely examples for explaining the positional relation of the components. Typically, the z-axis positive direction is a vertical upward direction and the xy plane is a horizontal plane throughout the drawings. Further, the shape of the heat sink shown in Fig. 1 is merely an example, and may be changed in various ways.

The base material B is a casting made of metal such as aluminum alloy having a high heat conductivity and is formed by die casting. As shown in Fig. 1, the base material B includes a body part B1 and a radiator fin B2. The alternate long and short dash line shown in Fig. 1 is an exemplary border between the body part B1 and the radiator fin B2. Fig. 1 shows a state in which the heat sink is placed on a horizontal plane (xy plane) in such a way that the radiator fin B2 faces upward (z-axis positive side). However, the heat sink may be placed in a flexible manner so that the radiator fin B2 can be oriented to any direction when the heat sink is used.

In the example shown in Fig. 1, the body part B1 includes a flat plate part having a rectangular shape in a plane view and a pair of side walls that are protruded in a z-axis negative direction from the respective ends of the flat plate part in the x-axis direction and extended in the y-axis direction.

The radiator fin B2 is extended in the y-axis direction on the upper surface of the flat plate part (principal surface on the z-axis positive side) in Fig. 1. In other words, the radiator fin B2 is provided on a principal surface opposite to the principal surface of the flat plate part in which the side walls are provided.

While the cross-sectional shape of the radiator fin B2 is a triangular shape in the example shown in Fig. 1, this is merely an example and may instead be a rectangular shape or the like. Further, while four radiator fins B2 are formed in the example shown in Fig. 1, the number of radiator fins B2 is not particularly limited.

The resin film F is composed of, for example, heat-radiation resin such as polyamide imide or polyimide and constitutes a heat-radiation resin-coated film provided on the radiator fin B2. As shown in Fig. 1, the resin film F is attached onto the radiator fin B2.

The resin film F may be directly bonded to the radiator fin B2 or may be bonded thereto using adhesive.

The resin film F has preferably a thickness between 10 and 100 µm. When the thickness of the resin film F is smaller than 10 µm, a sufficiently high heat radiation performance cannot be obtained. On the other hand, when the thickness of the resin film F exceeds 100 µm, the heat radiation performance is hardly improved, which causes the cost performance to be reduced.

### <Method of manufacturing Heat Sink>

With reference next to Fig. 2, a method of manufacturing the heat sink according to the first embodiment will be explained. Fig. 2 is a flowchart showing the method of manufacturing the heat sink according to the first embodiment. With reference to Fig. 1 as well as Fig. 2, the method of manufacturing the heat sink according to the first embodiment will be explained.

First, as shown in Fig. 2, after the base material B shown in Fig. 1 is die-cast, the base material B is taken out of the mold (Step ST1).

Next, as shown in Fig. 2, using residual heat of the base material B taken out of the mold, as shown in Fig. 1, the resin film F is bonded to the surface of the base material B (Step ST2). That is, the heat-radiation resin-coated film is formed on the surface of the base material B by bonding the resin film F to the radiator fin B2 of the base material B.

As described above, in the method of manufacturing the heat sink according to the first embodiment, the resin film F, which is the heat-radiation resin-coated film, is bonded to the surface of the base material B using the residual heat of the base material B taken out of the mold. Accordingly, there is no need to separately heat the base material B to form the heat-radiation resin-coated film, and thus productivity can be made high.

Further, by bonding the resin film F having a uniform thickness to the surface of the base material B, the heat-radiation resin-coated film is formed on the surface of the base material B. It is therefore possible to make the thickness of the heat-radiation resin-coated film formed on the surface of the base material B uniform.

That is, in the method of manufacturing the heat sink according to the first embodiment, it is possible to eliminate the need for separately heating the base material in order to form the heat-radiation resin-coated film, thereby making productivity high, and make the thickness of the heat-radiation resin-coated film formed on the surface of the base material uniform.

### <Details of Method of manufacturing Heat Sink>

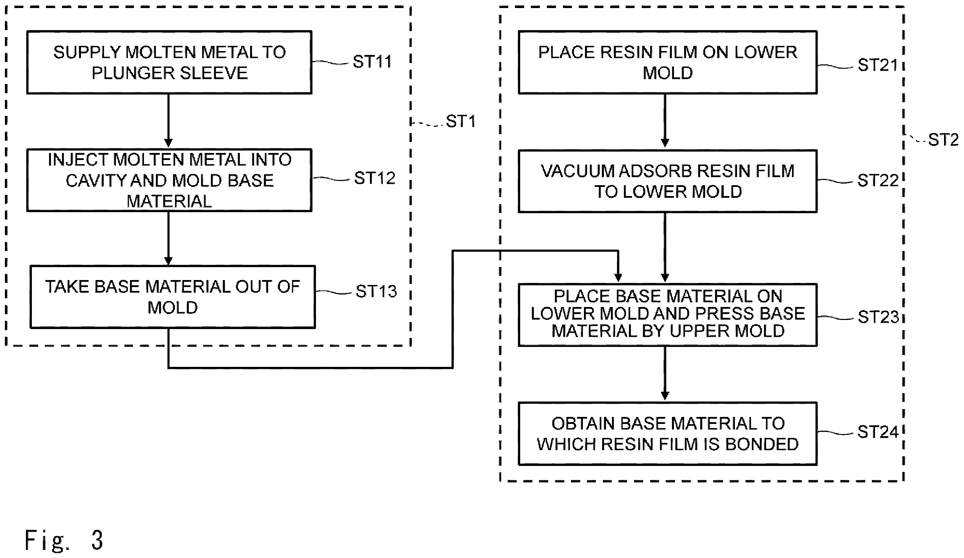

With reference next to Fig. 3, details of the method of manufacturing the heat sink according to the first embodiment will be explained. Fig. 3 is a flowchart showing the details of the method of manufacturing the heat sink according to the first embodiment.

Steps ST11-ST13 in Fig. 3 correspond to Step ST1 shown in Fig. 2, and correspond to the die-casting process of the base material B. Steps ST21-ST24 shown in Fig. 3 correspond to Step ST2 shown in Fig. 2, and correspond to the bonding process of the resin film F.

First, Steps ST11-ST13, which constitute the die-casting process (Step ST1) of the base material B, will be explained.

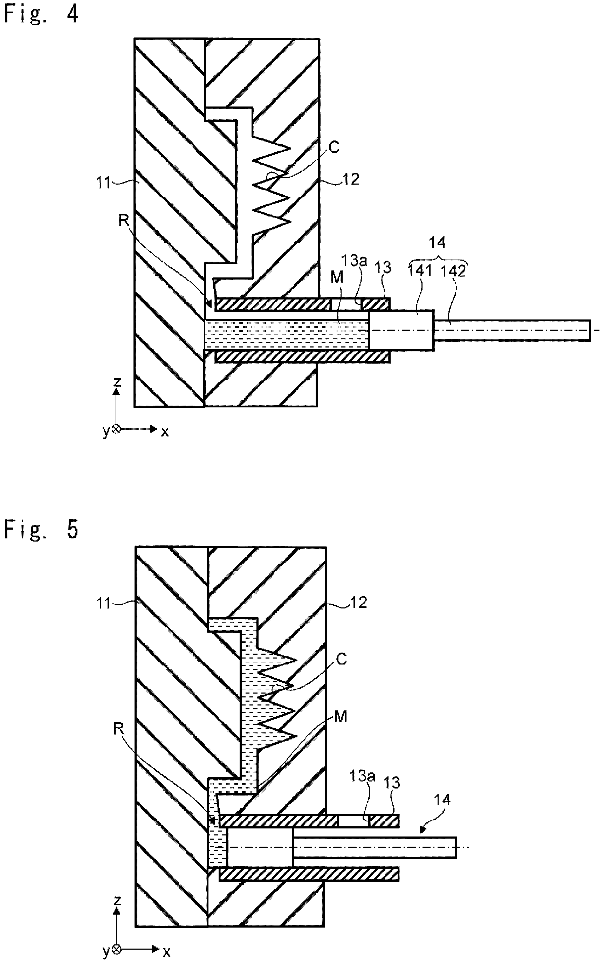

As shown in Fig. 3, in the die-casting process (Step ST1) of the base material B, molten metal is supplied to a plunger sleeve (Step ST11). Fig. 4 is a schematic cross-sectional view showing a state in which molten metal M is supplied to a plunger sleeve 13 in the die-casting process.

Specifically, as shown in Fig. 4, in a state in which a plunger tip 141 is retracted in the x-axis positive direction in the plunger sleeve 13, a movable mold 11 is made to come into contact with a fixed mold 12 to form a cavity C. Then the molten metal M is supplied to the plunger sleeve 13 from a supply port 13a formed on the upper surface of the back side (x-axis negative direction) of the plunger sleeve 13 using, for example, a ladle (not shown).

As shown in Fig. 4, the plunger sleeve 13 is a cylindrical member having a central axis parallel to the x axis and is fitted into a through-hole of the fixed mold 12. The plunger tip 141 slides in the plunger sleeve 13 in the x-axis direction. The plunger tip 141 is coupled to a driving source for sliding (not shown) such as a cylinder via a plunger rod 142. The plunger tip 141 and the plunger rod 142 form a plunger 14.

Next, as shown in Fig. 3, the molten metal is injected into the cavity and the base material is molded (Step ST12). Fig. 5 is a schematic cross-sectional view showing a state in which the injection of the molten metal M into the cavity C is completed in the die-casting process.

Specifically, as shown in Fig. 5, the plunger 14 is made to move forward in the plunger sleeve 13, and the molten metal M is injected into the cavity C via a runner R. By making the plunger 14 move at a high speed, the cavity C can be filled with the molten metal M while pressure is being applied to the molten metal M.

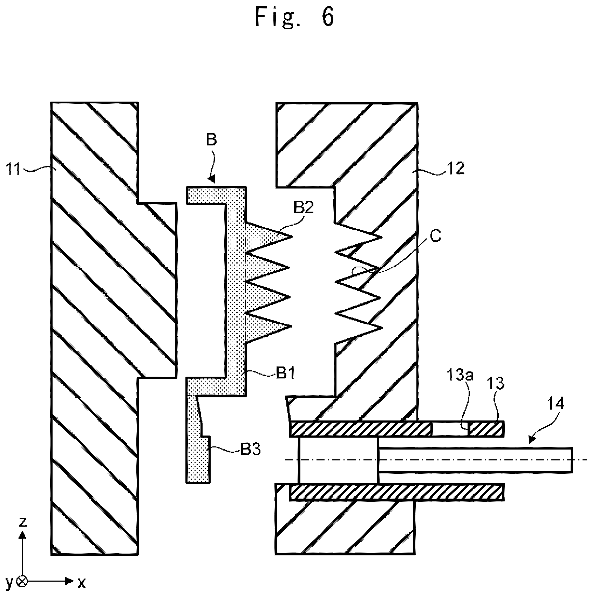

Next, as shown in Fig. 3, the molten metal is injected into the cavity and the base material is taken out of the mold (Step ST13). Fig. 6 is a schematic cross-sectional view showing a state in which the base material B is taken out of the mold (the movable mold 11 and the fixed mold 12) in the die-casting process.

Specifically, as shown in Fig. 6, after the molten metal M is solidified in the cavity C, the movable mold 11 is separated from the fixed mold 12 and the base material B that has been molded is obtained. As shown in Fig. 6, the base material B that has been molded includes, besides the body part B1 and the radiator fin B2 shown in Fig. 1, a biscuit/runner part B3. The alternate long and short dash line shown in the base material B in Fig. 6 is an exemplary border among the body part B1, the radiator fin B2, and the biscuit/runner part B3.

The biscuit/runner part B3 includes a thick biscuit part surrounded by the end surface of the plunger tip 141 and the mold (the movable mold 11 and the fixed mold 12) and the like in which the molten metal M is solidified and a thin runner part in which the molten metal M is solidified in the runner R. Since the biscuit/runner part B3 is finally removed, it is not shown in Fig. 1.

Next, Steps ST21-ST24, which constitute the bonding process (Step ST2) of the resin film F, will be explained.

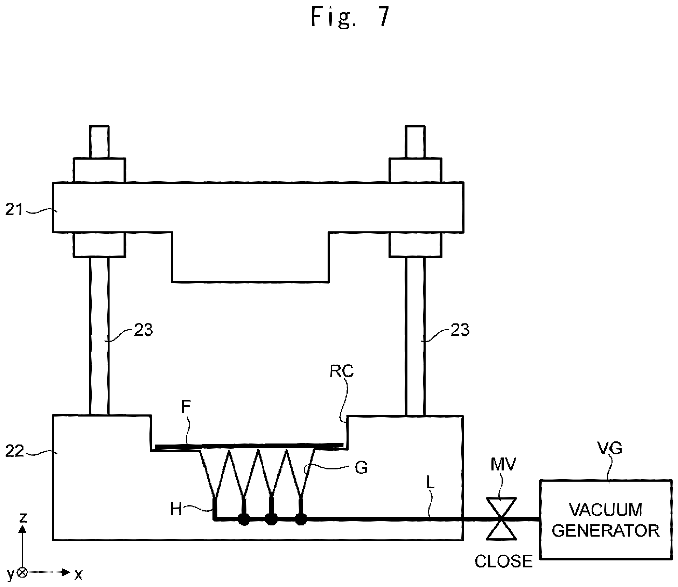

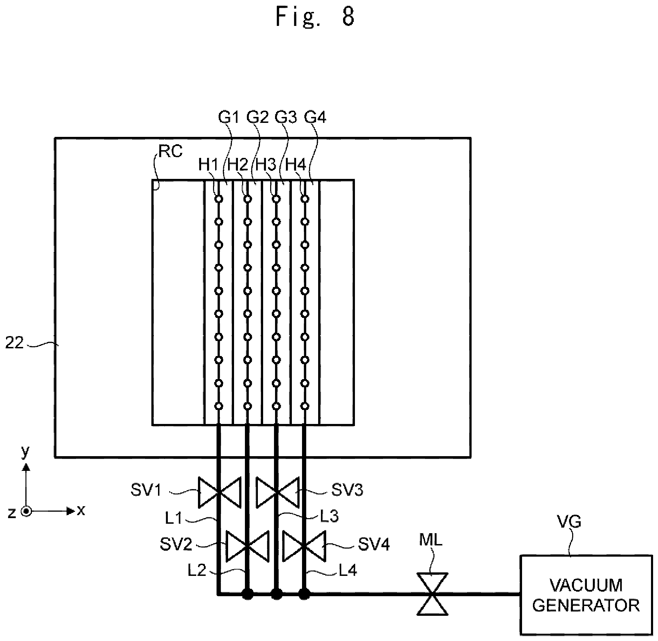

As shown in Fig. 3, in the bonding process of the resin film F (Step ST2), first, the resin film is placed on a lower mold (Step ST21). Fig. 7 is a schematic side view showing a state in which the resin film F is placed on a lower mold 22 in the bonding process. Further, Fig. 8 is a schematic plane view of the lower mold 22.

Specifically, as shown in Fig. 7, the resin film F is placed on the lower mold (die for bonding) 22 in a state in which an upper mold 21 is elevated in the z-axis positive direction. The resin film F is preferably preheated. The resin film F may be preheated, for example, by placing it on a die-casting mold which is conducting the casting process. The die-casting mold includes the movable mold 11 and the fixed mold 12. As a matter of course, the resin film F may be preheated by a heater.

The upper mold 21 slides in the z-axis direction along a pair of columns 23 extended in the z-axis direction. Further, as shown in Figs. 7 and 8, a recess RC that accommodates the body part B1 of the base material B is provided at the central part of the upper surface of the lower mold 22. As shown in Fig. 7, the resin film F is placed on the bottom surface of the recess RC.

Further, as shown in Fig. 7, grooves G having a shape that corresponds to the shape of the radiator fin B2 of the base material B are extended in the y-axis direction on the bottom surface of the recess RC. In the bottom part of the grooves G, vacuum holes H that vacuum-adsorb the resin film F are formed. The vacuum holes H are connected to a vacuum generator VG via a pipe L provided inside and outside of the lower mold 22. A main valve MV is provided on the pipe L outside the lower mold 22. As shown in Fig. 7, when the resin film F is placed on the lower mold 22, the main valve MV is closed. The diameter of each of the vacuum holes H is, for example, about 1 mm.

As shown in Fig. 8 as an example, four grooves G1-G4 are formed. In the groove G1, a large number of vacuum holes H1 are formed to align along the longitudinal direction of the groove G1. The vacuum holes H1 are connected to the vacuum generator VG by a pipe L1. A sub valve SV1 is provided on the pipe L1.

In a similar way, in the groove G2, a large number of vacuum holes H2 are formed to align along the longitudinal direction of the groove G2. The vacuum holes H2 are connected to the vacuum generator VG by a pipe L2. A sub valve SV2 is provided on the pipe L2.

In a similar way, in the groove G3, a large number of vacuum holes H3 are formed to align along the longitudinal direction of the groove G3. The vacuum holes H3 are connected to the vacuum generator VG by a pipe L3. A sub valve SV3 is provided on the pipe L3.

In a groove G4, a large number of vacuum holes H4 are formed to align along the longitudinal direction of the groove G4. The vacuum holes H4 are connected to the vacuum generator VG by a pipe L4. A sub valve SV4 is provided on the pipe L4.

The four sub valves SV1-SV4 are provided in parallel with respect to the vacuum generator VG.

According to the aforementioned structure, the grooves G1-G4 are able to adsorb the resin film F independently from one another.

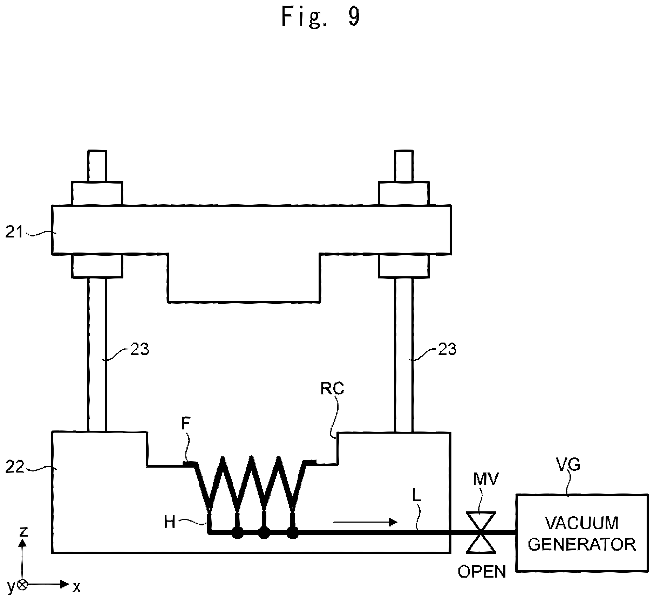

Next, as shown in Fig. 3, the resin film is vacuum adsorbed to the lower mold (Step ST22). Fig. 9 is a schematic side view showing a state in which the resin film F is vacuum adsorbed to the lower mold 22 in the bonding process.

Specifically, after the vacuum generator VG is driven and the main valve MV is opened, the four sub valves SV1-SV4 shown in Fig. 8 are opened. By the suction force via the vacuum holes H1-H4, as shown in Fig. 9, the resin film F is vacuum adsorbed to the lower mold 22.

When, for example, the four sub valves SV1-SV4 are opened at the same time, the resin film F may be pulled between the grooves G adjacent to each other and the resin film F may be broken. Accordingly, by sequentially opening the sub valves SV1-SV4 in this order, the resin film F can be sequentially adsorbed from the groove G1 positioned at the end of the x-axis negative direction toward the groove G4 positioned at the end of the x-axis positive direction. It is therefore possible to suppress a situation in which the resin film F is pulled between the grooves G that are adjacent to each other and it is broken.

As a matter of course, the effects similar to those stated above can be obtained even when the sub valves SV1-SV4 are sequentially opened in such a way that the resin film F is sequentially adsorbed from the groove G4 positioned at the end of the x-axis positive direction toward the groove G1 positioned at the end of the x-axis negative direction. Alternatively, the effects similar to those stated above can be obtained even when the sub valves SV1-SV4 are sequentially opened in such a way the resin film F is sequentially adsorbed toward the grooves G1 and G4 positioned at the above respective ends after it is first adsorbed by the groove G2 or G3 positioned at the center.

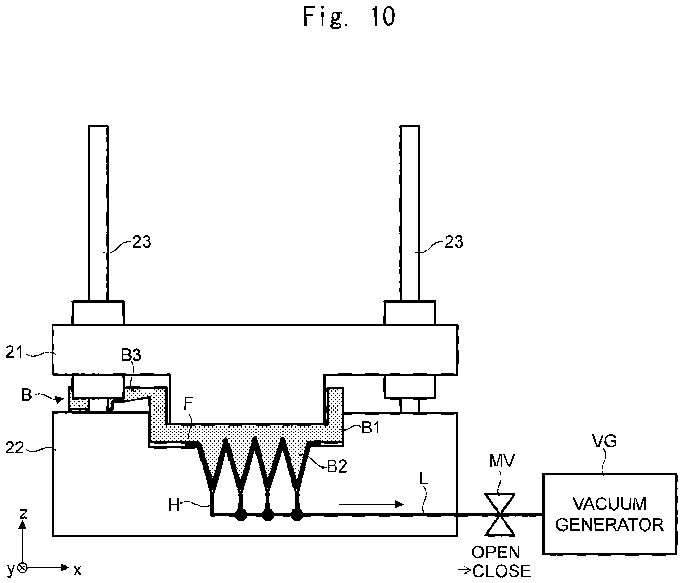

Next, as shown in Fig. 3, the base material having a high temperature taken out of the die-casting mold is placed on the lower mold and the base material is pressed by the upper mold (Step ST23). Fig. 10 is a schematic side view showing a state in which the base material B is placed on the lower mold 22 and the base material B is pressed by the upper mold 21 in the bonding process.

Specifically, as shown in Fig. 10, the base material B is placed on the lower mold 22 in such a way as to fit the radiator fin B2 of the base material B into the grooves G of the lower mold 22 that adsorbs the resin film F. Then the upper mold 21 is lowered to press the upper side (z-axis direction positive side) of the body part B1 of the base material B by the upper mold 21. After that, the main valve MV and the four sub valves SV1-SV4 shown in Fig. 8 are closed to cancel the vacuum adsorption of the resin film F to the lower mold 22. By the residual heat of the base material B which has just been die-cast and hence has a high temperature, the resin film F that has been vacuum adsorbed to the lower mold 22 is bonded to the surface of the radiator fin B2 of the base material B.

As described above, by interposing the resin film F between the lower mold 22 having a surface shape that corresponds to the shape of the surface of the base material B and the base material B, the resin film F is bonded to the surface of the base material B. It is therefore possible to efficiently bond the resin film F to the surface of the base material B. Further, in this case, in a state in which the resin film F is vacuum adsorbed to the lower mold 22, the resin film F is interposed between the lower mold 22 and the base material B. It is therefore possible to suppress wrinkles of the resin film F that may be generated at the bonding process.

When the resin film F is made of thermoplastic polyamide imide or polyimide, the temperature when the base material B is taken out of the die-casting mold (hereinafter this temperature will be referred to as a demolding temperature) is preferably 180-250 °C. When the demolding temperature is lower than 180 °C, the resin film F is not firmly bonded to the base material B. When the demolding temperature exceeds 250 °C, the molten metal M may remain inside the thick biscuit part in the biscuit/runner part B3, which may cause the thick biscuit part to burst.

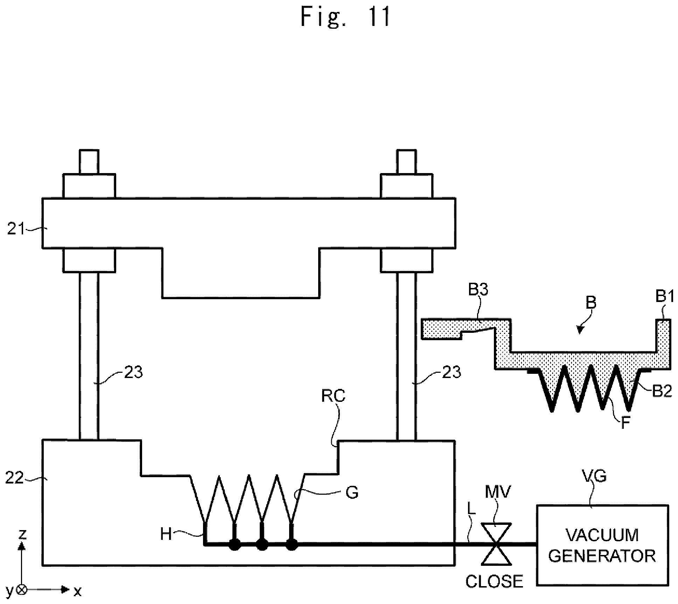

Lastly, as shown in Fig. 3, the base material to which the resin film is bonded is taken out of the lower mold (Step ST24). Fig. 11 is a schematic side view showing a state in which the base material B to which the resin film F is bonded is taken out of the lower mold 22 in the bonding process. As shown in Fig. 11, the upper mold 21 is elevated and the base material B to which the resin film F is bonded is taken out of the lower mold 22.

As described above, in the method of manufacturing the heat sink according to the first embodiment, the resin film F, which is the heat-radiation resin-coated film, is bonded to the surface of the base material B using the residual heat of the base material B taken out of the die-casting mold (the movable mold 11 and the fixed mold 12). Accordingly, there is no need to separately heat the base material B in order to form the heat-radiation resin-coated film and thus productivity can be made high.

Further, by bonding the resin film F having a uniform thickness to the surface of the base material B, the heat-radiation resin-coated film is formed on the surface of the base material B. Accordingly, it is possible to make the thickness of the heat-radiation resin-coated film formed on the surface of the base material B uniform.

That is, in the method of manufacturing the heat sink according to the first embodiment, it is possible to eliminate the need for separately heating the base material in order to form the heat-radiation resin-coated film, thereby making productivity high, and make the thickness of the heat-radiation resin-coated film formed on the surface of the base material uniform.

Further, in the method of manufacturing the heat sink according to the first embodiment, by bonding the resin film F having heat radiation to the surface of the base material B, the heat-radiation resin-coated film is formed on the surface of the base material B. Accordingly, it is possible to reduce the surface roughness of the heat-radiation resin-coated film compared to a case in which the heat-radiation resin-coated film is formed on the surface of the base material B by spraying the heat-radiation resin.

Further, in the method of manufacturing the heat sink according to the first embodiment, it is possible to form the heat-radiation resin-coated film only in an area in which the heat-radiation resin-coated film is necessary on the surface of the base material B.

Further, when spray coating is carried out, there may be an area in which the heat-radiation resin-coated film cannot be formed on the surface of the base material B due to a reason that the radiator fin B2 interrupts spray coating or the like. On the other hand, in the method of manufacturing the heat sink according to the first embodiment, it is possible to suppress the occurrence of the area in which the heat-radiation resin-coated film cannot be formed compared to the case in which spray coating is carried out.

### (Second Embodiment)

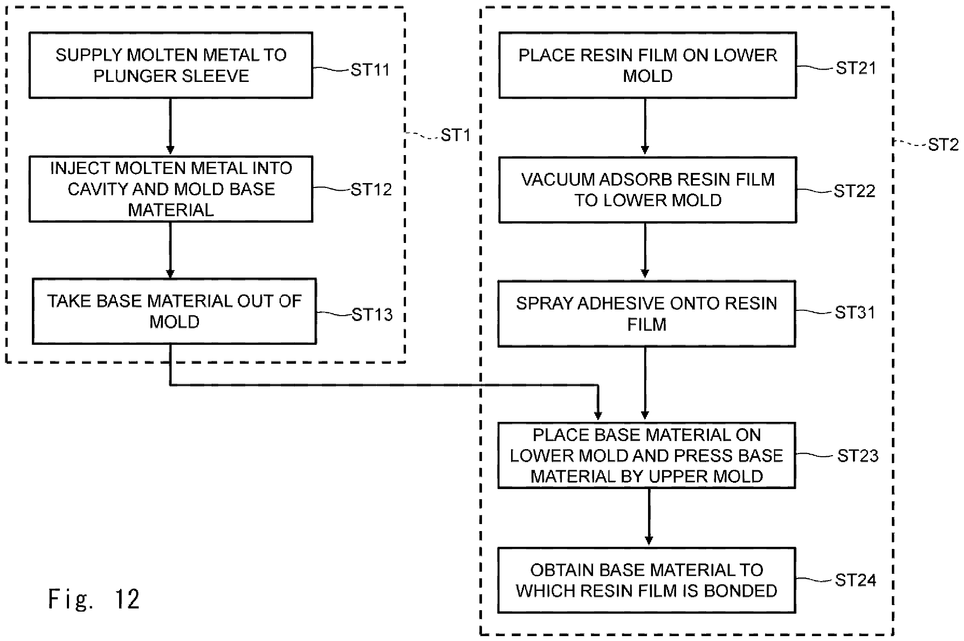

With reference next to Fig. 12, a method of manufacturing a heat sink according to a second embodiment will be explained. Fig. 12 is a flowchart showing details of the method of manufacturing the heat sink according to the second embodiment.

As shown in Fig. 12, in the method of manufacturing the heat sink according to the second embodiment, compared to the method of manufacturing the heat sink according to the first embodiment shown in Fig. 3, after Step ST22 in which the resin film is vacuum adsorbed to the lower mold but before Step ST23 in which the base material is placed on the lower mold and the base material is pressed by the upper mold, adhesive is sprayed onto the resin film (Step ST31). That is, in the method of manufacturing the heat sink according to the second embodiment, the resin film F is bonded to the surface of the base material B using adhesive.

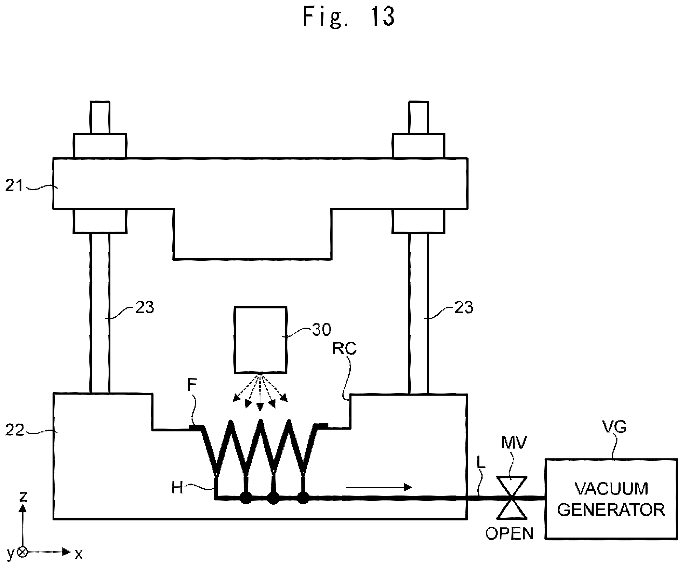

Fig. 13 is a schematic side view showing a state in which adhesive is sprayed onto the resin film F in the bonding process. As shown in Fig. 13, the adhesive is sprayed onto the resin film F that has been vacuum adsorbed to the lower mold 22 from above (z-axis positive direction) using a spraying device 30.

The adhesive is preferably epoxy-based resin, and more preferably, epoxy-based resin having heat radiation. In this case, the demolding temperature of the base material B is preferably 120-200 °C. When the demolding temperature is lower than 120 °C, the adhesive is not sufficiently cured. When the demolding temperature exceeds 200 °C, the adhesive may be deteriorated.

In the method of manufacturing the heat sink according to the second embodiment, the resin film F is bonded to the surface of the base material B using adhesive. Accordingly, it is possible to improve the bonding force between the resin film F and the base material B compared to the method of manufacturing the heat sink according to the first embodiment in which the resin film F is directly bonded to the surface of the base material B.

The resin film F may be bonded to the surface of the base material B manually, for example, without using a mold. Alternatively, the resin film F may be bonded to the surface of the base material B by pressing the resin film F onto the surface of the base material B using air.

A method of manufacturing a heat sink according to one aspect of the present disclosure is a method of manufacturing a heat sink including a base material having a surface on which a heat-radiation resin-coated film is formed, the method comprising: taking the base material out of a die-casting mold after the base material is die-cast; and forming the heat-radiation resin-coated film on the surface of the base material using residual heat of the base material taken out of the die-casting mold. In forming the heat-radiation resin-coated film, the heat-radiation resin-coated film is formed on the surface of the base material by bonding a heat-radiation resin film to the surface of the base material.

## Claims

1. A method of manufacturing a heat sink including a base material having a surface on which a heat-radiation resin-coated film is formed, the method comprising:
taking the base material (B) out of a die-casting mold (11, 12) after the base material is die-cast; and
forming the heat-radiation resin-coated film (F) on the surface of the base material using residual heat of the base material taken out of the die-casting mold, wherein
in forming the heat-radiation resin-coated film, the heat-radiation resin-coated film is formed on the surface of the base material by bonding a heat-radiation resin film to the surface of the base material,
the heat-radiation resin film is bonded to the surface of the base material by interposing the heat-radiation resin film between a die for bonding (22) having a surface shape that corresponds to the surface shape of the base material and the base material, wherein
a vacuum hole for vacuum adsorption (H) is provided in the die for bonding, and
the heat-radiation resin film is interposed between the die for bonding and the base material in a state in which the heat-radiation resin film is vacuum adsorbed to the die for bonding.

2. The method of manufacturing the heat sink according to Claim 1, comprising:
applying adhesive to a surface of the heat-radiation resin film; and
bonding the heat-radiation resin film to the surface of the base material using the adhesive.

3. The method of manufacturing the heat sink according to Claim 2, wherein the adhesive is made of heat-radiation resin.

## Patentansprüche

1. Verfahren zum Herstellen eines Wärmebeckens, das ein Basismaterial hat, das eine Fläche hat, auf der ein wärmestrahlungsharzbeschichteter Film ausgebildet ist, wobei das Verfahren folgende Schritte aufweist:
Herausnehmen des Basismaterials (B) aus einer Druckgussform (11, 12), nachdem das Basismaterial druckgegossen worden ist; und
Ausbilden des wärmestrahlungsharzbeschichteten Films (F) auf der Oberfläche des Basismaterials unter Verwendung einer Restwärme des Basismaterials, das aus der Druckgussform herausgenommen worden ist, wobei
beim Ausbilden des wärmestrahlungsharzbeschichteten Films, der wärmestrahlungsharzbeschichtete Film auf der Oberfläche des Basismaterials durch Bonden eines Wärmestrahlungsharzfilms mit der Oberfläche des Basismaterials ausgebildet wird,
der Wärmestrahlungsharzfilm mit der Oberfläche des Basismaterials durch Anordnen des Wärmestrahlungsharzfilms zwischen einem Werkzeug (22) zum Bonden, das eine Oberflächenform hat, die der Oberflächenform des Basismaterials entspricht, und dem Basismaterial gebondet wird, wobei
ein Unterdruckloch (H) zur Unterdruckadsorption in dem Werkzeug zum Bonden vorgesehen ist, und
der Wärmestrahlungsharzfilm zwischen dem Werkzeug zum Bonden und dem Basismaterial in einem Zustand angeordnet wird, in dem der Wärmestrahlungsharzfilm an dem Werkzeug zum Bonden unterdruckadsorbiert ist.

2. Verfahren zum Herstellen des Wärmebeckens nach Anspruch 1, des Weiteren mit den folgenden Schritten:
Aufbringen eines Adhäsivs auf eine Oberfläche des Wärmestrahlungsharzfilms; und
Bonden des Wärmestrahlungsharzfilms mit der Oberfläche des Basismaterials unter Verwendung des Adhäsivs.

3. Verfahren zum Herstellen des Wärmebeckens nach Anspruch 2, wobei das Adhäsiv aus einem Wärmestrahlungsharz gemacht ist.

## Revendications

1. Procédé de fabrication d'un dissipateur thermique comprenant un matériau de base ayant une surface sur laquelle est formé un film revêtu de résine de rayonnement thermique, le procédé comprenant :
le retrait du matériau de base (B) hors d'un moule pour coulée sous pression (11, 12) après que le matériau de base a été coulé sous pression ; et
la formation du film revêtu de résine de rayonnement thermique (F) sur la surface du matériau de base par utilisation de la chaleur résiduelle du matériau de base retiré du moule pour coulée sous pression, dans lequel
lors de la formation du film revêtu de résine de rayonnement thermique, le film revêtu de résine de rayonnement thermique est formé sur la surface du matériau de base par collage d'un film de résine de rayonnement thermique à la surface du matériau de base,
le film de résine de rayonnement thermique est collé à la surface du matériau de base par interposition du film de résine de rayonnement thermique entre une matrice de collage (22) ayant une forme de surface qui correspond à la forme de surface du matériau de base et le matériau de base,
dans lequel un trou de vide pour l'adsorption sous vide (H) est présent dans la matrice pour le collage, et
le film de résine de rayonnement thermique est interposé entre la matrice pour le collage et le matériau de base dans un état dans lequel le film de résine de rayonnement thermique est adsorbé sous vide sur la matrice pour le collage.

2. Procédé de fabrication d'un dissipateur thermique selon la revendication 1, comprenant :
l'application d'adhésif sur une surface du film de résine de rayonnement thermique ; et
le collage du film de résine de rayonnement thermique à la surface du matériau de base par utilisation de l'adhésif.

3. Procédé de fabrication d'un dissipateur thermique selon la revendication 2, dans lequel l'adhésif est fait d'une résine de rayonnement thermique.
